(19) Europäisches Patentamt
European Patent Office
Office européen des brevets

(11) **EP 4 495 616 A1**

(12) **EUROPEAN PATENT APPLICATION**

(43) Date of publication:
**22.01.2025 Bulletin 2025/04**

(21) Application number: **23186623.7**

(22) Date of filing: **20.07.2023**

(51) International Patent Classification (IPC):
**G01R 31/392** (2019.01)   **G01R 31/396** (2019.01)

(52) Cooperative Patent Classification (CPC):
**G01R 31/392; G01R 31/396;** G01R 31/367

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: TWAICE Technologies GmbH
**80807 München (DE)**

(72) Inventors:
• **BERG, Philipp**
**81827 München (DE)**
• **GOKULAKRISHNAN, Gokulakrishnan**
**89075 Ulm (DE)**
• **FAIZI, Saifullah**
**80937 München (DE)**

(74) Representative: **Kraus & Lederer PartGmbB**
**Thomas-Wimmer-Ring 15**
**80539 München (DE)**

(54) **CALCULATION OF EFFECTIVE STATE OF CHARGE**

(57)   An effective state of charge, SOC, of a rechargeable battery is determined based on a maximum voltage (101) and minimum voltage (102) reported for a sampling time interval for cell components in a super-component. This enables to more accurately determine the state of health, SOH, of the battery.

FIG. 1

**Description**

TECHNICAL FIELD

Various examples of the disclosure generally pertain to assessing rechargeable batteries such as lithium-ion batteries. Various examples of the disclosure specifically relate to determining an effective state of charge considering upper and lower voltage limits imposed by a battery management system on cell component level.

BACKGROUND

A lithium-ion battery comprises multiple cell components. Each cell component includes one or more cells; each cell includes a positive electrode (cathode), a negative electrode (anode), and an electrolyte. The anode is generally made of carbon, such as graphite, while the cathode is typically a metal oxide, such as lithium cobalt oxide, lithium iron phosphate, or lithium nickel manganese cobalt oxide. The electrolyte is a lithium salt in an organic solvent.

When multiple cell components are connected in series, they form a string. The string can also be referred to as super-component. Connecting cell components in series increases the voltage tapped at the beginning and end of the string: the string voltage of the string is the sum of the voltages of the individual cell components.

The battery also includes a battery management system (BMS). The BMS monitors the voltage of individual cell components. The BMS monitors the voltage of the cell components to avoid excessive charging and excessive discharging of individual cell components. If the voltage of a cell exceeds an upper voltage limit, it is considered overcharged, which can damage the cell and potentially cause a safety risk. Likewise, if a cell's voltage falls below a lower voltage limit, it can damage the cell and thus reduce the lifespan of the battery.

Oftentimes, BMS are configured to suspend charging the battery responsive to detecting that any one of the cell components has reached the upper voltage limit; and to suspend discharging of the battery responsive to detecting that any one of the cells has reached the lower voltage limit.

It has been found that this behavior of the BMS can limit the ability to correctly determine the state of charge (SOC) of the battery and the state of health (SOH) of the battery.

SUMMARY

Accordingly, a need exists for advanced techniques of assessing a battery, e.g., determining SOC and/or SOH. A need exists for techniques that take into account limitations on charging and discharging imposed by the BMS.

This need is met by the features of the independent claims. The dependent claims define embodiments.

Various disclosed techniques are based on the finding that upper and lower voltage limits enforced by the BMS effectively limit the available capacity of the battery. Thus, according to the disclosed techniques, an effective SOC is determined that takes into account the voltages of the cells with highest and lowest voltages in a super-component that limits the effectively available capacity.

A computer-implemented method of assessing a battery is disclosed. The battery includes a battery management system. The battery further includes a string that includes multiple cell components. The multiple cell components of the string are electrically coupled in series. The battery management system suspends charging and discharging of the multiple cell components responsive to one f the multiple cell components reaching an upper voltage limit or a lower voltage limit. The method includes determining a first SOC for a sampling interval. This first SOC is determined based on the minimum voltage across the multiple cell components. The method also includes determining a second SOC based on the maximum voltage across the multiple cell components; this is for the same sampling interval. The method also includes determining an effective SOC of the string by scaling between the first SOC and the second SOC. The effective SOC is determined for the sampling interval.

A computing device includes a memory that stores program code that can be loaded and executed by a processor of the computing device. The processor, upon executing the program code, performs such a method. For example, the computing device can be a cloud server or a PC. The processor can be a general-purpose central processing unit (CPU).

It is to be understood that the features mentioned above and those yet to be explained below may be used not only in the respective combinations indicated, but also in other combinations or in isolation without departing from the scope of the invention.

BRIEF DESCRIPTION OF THE DRAWINGS

FIG. 1 schematically illustrates voltages of cell components of a string of cell components and an effective state of charge for a charging-discharging cycle.

FIG. 2 is a flowchart of a method according to various examples.

DETAILED DESCRIPTION

In the following, embodiments of the invention will be described in detail with reference to the accompanying drawings. It is to be understood that the following description of embodiments is not to be taken in a limiting sense. The scope of the invention is not intended to be limited by the embodiments described hereinafter or by the drawings, which are taken to be illustrative only.

Hereinafter, techniques of assessing a rechargeable battery such as a lithium-ion battery, are disclosed.

Hereinafter, techniques of determining the SOC are disclosed. The SOC is usually expressed as a percentage. The SOC indicates the amount of electrical energy currently stored in a battery compared to its current maximum capacity. It is defined as:

$$\text{SoC} = (\text{Current Capacity} / \text{Current Maximum Capacity}) * 100\%$$

Here, Current Capacity is the amount of charge the battery currently holds, and Current Maximum Capacity is the total amount of energy that the battery can store when it is fully charged (considering ageing).

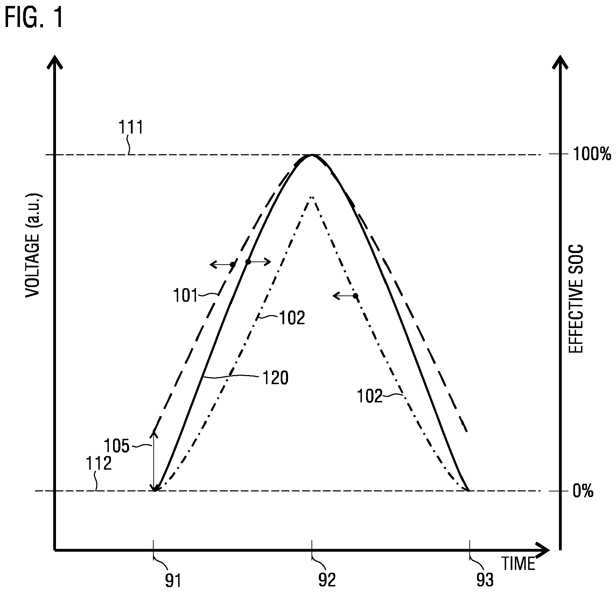

Various techniques are based on the finding the current capacity can sometimes effectively be limited by safety functions of the BMS. In particular, a cell component imbalance can limit the ability of fully discharging all cell components or fully charging all cell components. Accordingly, the SOC can be affected by the safety functions of the BMS. An effective SOC taking this effect into account can be calculated. This is explained in detail in connection with FIG. 1.

FIG. 1 illustrates a voltage 101 of a first cell component (dashed line in FIG. 1; left vertical axis) and a voltage 102 of a second cell component (dashed-dotted line in FIG. 1; left vertical axis). While FIG. 1 only illustrates the voltage 101 and the voltage 102 of two cell components of the string, as a general rule, the string can include additional cell components. FIG. 1 illustrates the voltage 101 and the voltage 102, because these are the minimum and maximum cell component voltages across all the cell components of the string (super-component). The other voltages of the cell components are arranged in between the voltage 101 and the voltage 102.

More specifically, FIG. 1 illustrates the evolution of the voltages 101, 102 over a charging and discharging cycle (horizontal axis illustrates time). Charging commences at time 91. At time 91, the voltage 102 equals a predefined lower voltage limit 112. This means that the BMS of the battery prevents further discharging of the battery. At time 91, the voltage 101 has - due to a cell component imbalance - not yet reached the lower voltage limit 112. The respective voltage difference 105 is highlighted in FIG. 1. This imbalance / voltage difference 105 means that even though the cell component associated with the voltage 101 still has remaining capacity, the respective capacity cannot be used for powering a load. The depth of discharge of the overall string is limited by the voltage 102 and the depth of discharge of that cell component. Accordingly, the effective SOC 120 (full line in FIG. 1; right axis) is zero.

Then, between time 91 and time 92, charging is carried out. The BMS monitors the voltages of each cell component and detects, at time 92, that the voltage 101 of the first cell component has reached a predefined upper voltage limit 111. Accordingly, charging of the battery is suspended at time 92 by the BMS safety functionality. This occurs prior to the voltage 102 reaching the upper voltage limit 111. I.e., even though the cell component associated with the voltage 102 would be able to hold additional capacity, it is not further charged. Accordingly, at time 92, the effective SOC has reached 100%. Then, discharging occurs until time 93. Again, at time 93, the voltage 102 reaches the lower voltage limit 112 and thus limits the discharging.

The particular cell component that exhibits the minimum cell component voltage across all cell components, as well as the particular cell component that exhibits the maximum cell component voltage across all cell components can change over the course of time. In other words, for a first charging and discharging cycle a given cell component can exhibit the minimum cell component voltage, while for a later, second charging and discharging cycle another cell component can exhibit the minimum cell component voltage.

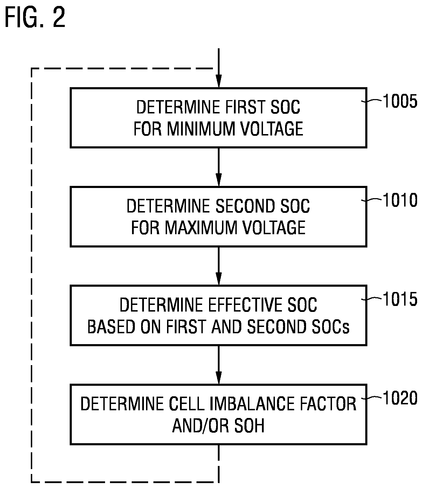

FIG. 2 schematically illustrates a method of assessing a battery. In particular, an effective SOC of a string of cell components can be determined. The effective SOC takes into account upper and lower voltage limits enforced by a safety functionality of a BMS of the battery on cell component level.

The method of FIG. 2 is computer implemented. For instance, the method of FIG. 2 can be implemented at the BMS of the battery. It would also be possible that the method of FIG. 2 is executed at a computer that obtains reports from the BMS. For instance, the method of FIG. 2 can be implemented at a cloud server. The method of FIG. 2 can be executed by a processor, upon loading program code from a memory and upon executing the program code.

The method commences at box 1005. At box 1005, a first SOC is determined based on the minimum voltage observed across all cell components of a string of cell components. For instance, referring to FIG. 1, it would be possible to determine a SOC for the cell component associated with the voltage 102 (cf. FIG. 1).

As a general rule, each cell component can include one or more cells electrically coupled in series and/or in parallel. Voltage reporting can be implemented on cell component level, i.e., the BMS may report one voltage value per cell component. There are various options available for determining a SOC based on a voltage. Examples include using a lookup table linking voltage the SOC or using a model-based approach, e.g., in combination with the Kalman filter. Prior art techniques for determining a SOC based on a voltage can be employed. The particular calculation technique is not germane for the techniques disclosed herein. Generally speaking, the SOC increases (decreases) with increasing (decreasing) voltage (cf. FIG. 1).

Then, the method commences at box 1010. At box 1010, a second SOC is determined based on the maximum voltage observed across also components of a string of cell components. For instance, referring to FIG. 1, it would be possible to determine a SOC for the cell component associated with the voltage 101.

Box 1010 and box 1005 are executed for the same sampling interval based on reports from the BMS or sensors at cell component level. The sampling interval may have a duration of seconds or minutes.

Then, at box 1015, it is possible to scale between the first SOC determined at box 1005 and the second SOC determined at box 1010, to determine an effective SOC for the string of cell components. Scaling between the first SOC and the second SOC means that the effective SOC is somewhere in between the first SOC and the second SOC, in accordance with the scaling.

In a first scenario, the average can be formed. In a second scenario, the impact of the first SOC and the second SOC depends on the effective SOC. A qualitative approach to such dynamic scaling is illustrated in FIG. 1. Here, closer to the time 91, the effective SOC 120 is primarily governed by the minimum voltage 102; closer to the time 92, the effective SOC 120 is governed by the maximum voltage 101. In between time 91 and time 92, a gradual transition is applied. Next, one possible quantitative implementation of such qualitative behavior of the scaling is discussed.

In some examples, the effective SOC is calculated based on the SOC determined for the maximum observed voltage across all cell components $SOC_{max}$ (cf. FIG. 1: voltage 101) and the SOC determined for the minimum observed voltage across all cell components $SOC_{min}$ (cf. FIG. 1: voltage 102). The effective SOC is scaled between the $SOC_{max}$ and $SOC_{min}$. When operating closer to the lower voltage limit, the effective SOC is primarily governed by SOC_min; when operating closer to the upper voltage limit, the effective SOC is primarily governed by $SOC_{max}$.

For instance, it has been found that the string voltage - i.e., the sum of all voltages of the cell components of the string - is a reliable measure to regulate such scaling. The string voltage provides information whether the string is closer to the lower or upper voltage limit. For instance, it would be possible to determine the string voltage and then respectively weigh between $SOC_{min}$ and $SOC_{max}$ using the string voltage directly.

In a more sophisticated scenario, a weighting factor can be used to calculate the effective SOC based on $SOC_{max}$ and $SOC_{min}$. This is explained next. The weighting factor w can be defined as:

$$SOC_{eff} = w \cdot SOC_{min} + (1-w) \cdot SOC_{max}$$

$$(1)$$

Here, w is a weighting factor (the weighting factor can also be referred to as scaling factor) that regulates the scaling between the $SOC_{min}$ and $SOC_{max}$. The weighting factor is determined so that $0 \leq w \leq 1$.

There are, as a general rule, various options available for calculating the scaling factor. In particular, the weighting factor can be calculated based on a SOC determined based on the string voltage.

One option to calculate the weighting factor is provided below:

$$w = \frac{SOC_{string-ref,max} - SOC_{string}}{SOC_{string-ref,max} - SOC_{string-ref,min}}$$

$$(2)$$

Here, the weighting factor is determined based on a relationship between the string SOC and an upper reference SOC $SOC_{string-ref,max}$ and a lower reference SOC $SOC_{string-ref,min}$ associated with the string. For instance, the historic maximum string SOC and historic maximum string SOC could be used as $SOC_{string-ref,max}$ and $SOC_{string-ref,min}$, respectively. It would also be possible to define $SOC_{string-ref,max} := 1$ and $SOC_{string-ref,min} := 0$.

For instance, the historic minimum string SOC can be retained by a respective memory. Each time a new string SOC is determined, it can be compared against the historic minimum string SOC retained in the memory; if the newly determine string SOC is smaller than the historic minimum string SOC stored in the memory, the memory can be overwritten. Such a procedure also applies for the historic maximum string SOC.

Once the effective SOC has been determined, at box 1020, it is possible to determine a SOH of the battery based on the effective SOC. Again, reference techniques for determining the SOH of the battery based on a SOC can be employed. The particular type of calculation used for determining the SOH based on the effective SOC is out of scope of the subject application is not germane for the techniques disclosed herein.

The SOH being determined based on the effective SOC increases the accuracy of the SOH. This is because the SOH - defined as the relationship of the maximum actually usable capacity if compared to the initially capacity - is not overestimated as in a scenario in which individual cell-component SOCs are used. It is rather limited in accordance with the effective SOC. It also complies with SOH measures that are observed by a BMS.

Alternatively or additionally to calculating the SOH, it would be possible to determine a cell imbalance factor that characterizes the imbalance between the cell components of the string. This cell imbalance factor can correspond to the spread of the voltages observed amongst the cell components (cf. FIG. 1) and/or a spread of SOC is determined for each cell voltage of the cell components of the string.

Generally, such cell component imbalance factor, quantifying the impact of the cell component imbalance, can be used as an indicator for a degradation of the battery. Accordingly, it would be possible that the SOH is further determined based on the cell component imbalance factor. An increase in the cell component imbalance can be indicative of aging of the battery, i.e., a reduced SOH.

As illustrated by the dashed line in FIG. 2, it is possible to reiterate box 1005 - box 1020 for a further sampling interval. Here, other cell components can exhibit minimum and maximum cell component voltages as in the previous iteration.

The flowchart of FIG. 2 schematically illustrates the method and variants are possible. For instance, it would be possible to execute box 1005 and box 1010 in parallel.

Although the invention has been shown and described with respect to certain preferred embodiments, equivalents and modifications will occur to others skilled in the art upon the reading and understanding of the specification. The present invention includes all such equivalents and modifications and is limited only by the scope of the appended claims.

For illustration, above, scenarios have been disclosed according to which a super-component is formed by multiple cell components being electrically connected in series. In further examples, a super-component can be formed by multiple cell components being electrically connected in parallel. Also, combinations are possible, employing both series as well as parallel connections.

## Claims

1. A computer-implemented method of assessing a battery, the battery comprising a battery management system and a string comprising multiple cell components coupled electrically in series, the battery management system suspending charging and discharging of the multiple cell components responsive to one of the multiple cell components reaching an upper voltage limit or a lower voltage limit,
   wherein the method comprises:

   - determining (1005), for a sampling interval, a first state of charge, SOC, based on the minimum voltage across (102) the multiple cell components,
   - determining (1010), for the sampling interval, a second SOC based on the maximum voltage (101) across the multiple cell components, and
   - determining (1015), for the sampling interval, an effective SOC (120) of the string by scaling between the first SOC and the second SOC.

2. The computer-implemented method of claim 1,
   wherein said scaling is based on a string voltage of the string measured for the sampling interval across the multiple cell components.

3. The computer-implemented method of claim 2,
   wherein said scaling is based on a weighting factor for regulating an impact of the first SOC and the second SOC on the effective SOC, the weighting factor being determined based on a third SOC determined based on the string voltage.

4. The computer-implemented method of claim 3,
   wherein the weighting factor is determined based on a relationship between the third SOC and both an upper reference SOC associated with the string as well as a lower reference SOC associated with the string.

5. The computer-implemented method of claim 4,

   wherein the upper reference SOC is a historic maximum SOC determined for the string,
   wherein the lower reference state of charge is a historic minimum SOC determined for the string.

6. The computer-implemented method of any one of the preceding claims, further comprising:

   - determining a state of health of the battery based on the effective SOC.

7. The computer-implemented method of any one of the preceding claims, further comprising:

   - determining a cell component imbalance factor based on the minimum cell voltage and the maximum cell voltage.

8. The computer-implemented method of claim 6 or 7,
   wherein the state of health is further determined based on the cell component imbalance factor.

9. A computing device comprising a memory storing program code that can be loaded and executed by a processor of the computing device, the processor, upon executing the program code, being configured to perform the method of any one of claims 1 to 8.

FIG. 1

FIG. 2

```
┌──────────────────────────┐
│   DETERMINE FIRST SOC     │──1005
│   FOR MINIMUM VOLTAGE     │
└──────────────────────────┘
             │
             ▼
┌──────────────────────────┐
│   DETERMINE SECOND SOC    │──1010
│   FOR MAXIMUM VOLTAGE     │
└──────────────────────────┘
             │
             ▼
┌──────────────────────────┐
│   DETERMINE EFFECTIVE SOC │──1015
│ BASED ON FIRST AND SECOND SOCs │
└──────────────────────────┘
             │
             ▼
┌──────────────────────────┐
│ DETERMINE CELL IMBALANCE FACTOR │──1020
│         AND/OR SOH       │
└──────────────────────────┘
```

Europäisches
Patentamt

European
Patent Office

Office européen
des brevets

# EUROPEAN SEARCH REPORT

Application Number

EP 23 18 6623

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2015/106044 A1 (DRIEMEYER-FRANCO ANA-LUCIA [FR] ET AL) 16 April 2015 (2015-04-16) | 1,7,9 | INV.<br>G01R31/392<br>G01R31/396 |
| Y | * paragraph [0058] – paragraph [0068]; figures fig. 6-7 * | 2-6,8 | |
| X | US 2017/016961 A1 (LUCEA MARC [FR]) 19 January 2017 (2017-01-19) | 1,7,9 | |
| Y | * paragraph [0042] – paragraph [0057]; figures 5-6 * | 2-6,8 | |
| Y | EP 3 916 411 A1 (MINTECH CO LTD [KR]) 1 December 2021 (2021-12-01) | 2-6,8 | |
| A | * paragraph [0117] – paragraph [0144]; figures 8-9 * | 1,7,9 | |
| A | CN 114 035 072 A (UNIV CHONGQING; XIE JIANBO; LIU HUABIN; LI JIE; SHU JUNHAO) 11 February 2022 (2022-02-11) * paragraph [0118] – paragraph [0124] * | 1-9 | |
| A | GB 2 478 557 A (RICARDO UK LTD [GB]) 14 September 2011 (2011-09-14) * page 24, line 10 – page 24, line 31 * | 1-9 | TECHNICAL FIELDS SEARCHED (IPC)<br><br>G01R |
| A | US 2020/132782 A1 (HONG SUNG JU [KR] ET AL) 30 April 2020 (2020-04-30) * paragraph [0049] * | 1-9 | |

The present search report has been drawn up for all claims

| Place of search | Date of completion of the search | Examiner |
|---|---|---|
| Munich | 9 January 2024 | Ako, Thomas |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 23 18 6623

This annex lists the patent family members relating to the patent documents cited in the above-mentioned European search report.
The members are as contained in the European Patent Office EDP file on
The European Patent Office is in no way liable for these particulars which are merely given for the purpose of information.

09-01-2024

| Patent document cited in search report | | | Publication date | Patent family member(s) | | | Publication date |
|---|---|---|---|---|---|---|---|
| US | 2015106044 | A1 | 16-04-2015 | CN | 104303064 | A | 21-01-2015 |
| | | | | EP | 2847603 | A1 | 18-03-2015 |
| | | | | FR | 2990516 | A1 | 15-11-2013 |
| | | | | JP | 6509725 | B2 | 08-05-2019 |
| | | | | JP | 2015524048 | A | 20-08-2015 |
| | | | | KR | 20150020270 | A | 25-02-2015 |
| | | | | US | 2015106044 | A1 | 16-04-2015 |
| | | | | WO | 2013167833 | A1 | 14-11-2013 |
| US | 2017016961 | A1 | 19-01-2017 | CN | 106133540 | A | 16-11-2016 |
| | | | | EP | 3114493 | A1 | 11-01-2017 |
| | | | | FR | 3018360 | A1 | 11-09-2015 |
| | | | | JP | 6543263 | B2 | 10-07-2019 |
| | | | | JP | 2017510800 | A | 13-04-2017 |
| | | | | KR | 20160130389 | A | 11-11-2016 |
| | | | | US | 2017016961 | A1 | 19-01-2017 |
| | | | | WO | 2015132544 | A1 | 11-09-2015 |
| EP | 3916411 | A1 | 01-12-2021 | CN | 113678009 | A | 19-11-2021 |
| | | | | EP | 3916411 | A1 | 01-12-2021 |
| | | | | JP | 7232548 | B2 | 03-03-2023 |
| | | | | JP | 2022522733 | A | 20-04-2022 |
| | | | | US | 2022146585 | A1 | 12-05-2022 |
| | | | | WO | 2021107220 | A1 | 03-06-2021 |
| CN | 114035072 | A | 11-02-2022 | NONE | | | |
| GB | 2478557 | A | 14-09-2011 | NONE | | | |
| US | 2020132782 | A1 | 30-04-2020 | CN | 110753849 | A | 04-02-2020 |
| | | | | EP | 3627166 | A1 | 25-03-2020 |
| | | | | JP | 7041800 | B2 | 25-03-2022 |
| | | | | JP | 2020508629 | A | 19-03-2020 |
| | | | | KR | 20190040888 | A | 19-04-2019 |
| | | | | US | 2020132782 | A1 | 30-04-2020 |

EPO FORM P0459

For more details about this annex : see Official Journal of the European Patent Office, No. 12/82